(19) Europäisches Patentamt
European Patent Office
Office européen des brevets

(11) EP 4 609 276 B1

# (12) EUROPEAN PATENT SPECIFICATION

(45) Date of publication and mention of the grant of the patent:
**29.07.2026 Bulletin 2026/31**

(21) Application number: **23798062.8**

(22) Date of filing: **04.10.2023**

(51) International Patent Classification (IPC):
***G06F 1/16*** $^{(2006.01)}$ ***H04M 1/02*** $^{(2006.01)}$
***H05K 5/00*** $^{(2025.01)}$ ***F16B 5/06*** $^{(2006.01)}$

(52) Cooperative Patent Classification (CPC):
**G06F 1/1616; F16B 5/0635; F16B 5/0664; F16B 7/182; F16B 21/071; F16B 31/021; G06F 1/1637; G06F 1/1656; G06F 1/1658; H04M 1/0252;** H04M 1/0266; H04M 1/0287

(86) International application number:
**PCT/US2023/075925**

(87) International publication number:
**WO 2024/091776 (02.05.2024 Gazette 2024/18)**

## (54) RECYCLABLE PLASTIC ASSEMBLY

RECYCELBARE KUNSTSTOFFANORDNUNG

ENSEMBLE PLASTIQUE RECYCLABLE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **28.10.2022 US 202263420121 P**
**28.11.2022 EP 22209774**

(43) Date of publication of application:
**03.09.2025 Bulletin 2025/36**

(73) Proprietor: **Covestro LLC**
**Pittsburgh, PA 15205 (US)**

(72) Inventors:
- **BONDI, Mark**
  **Pittsburgh, Pennsylvania 15205 (US)**
- **IMMORMINO, Anthony**
  **Pittsburgh, Pennsylvania 15205 (US)**
- **MATSCO, Joel**
  **Pittsburgh, Pennsylvania 15205 (US)**

(74) Representative: **Levpat**
**c/o Covestro AG**
**Gebäude K12**
**51365 Leverkusen (DE)**

(56) References cited:
**WO-A1-2022/152560 US-A- 5 808 863**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 609 276 B1

## Description

### FIELD OF THE INVENTION

The present invention relates in general to, a human-machine interface (HMI) made from plastic assemblies and more specifically to, recyclable thermoplastic assemblies, such as laptop covers.

### BACKGROUND OF THE INVENTION

Traditional laptops are constructed from materials and by processes that are unsatisfactory for sustainability and recycling. As those skilled in the art are aware, the A and B covers of a laptop are typically joined using one-way snap fits, adhesive tapes, adhesives, and many screws and metal screw bosses. The joining method changes based on the cost of the laptop. Before recycling can begin, these metal parts including metal-threaded inserts must be removed from the part into which it is embedded. Removal of these metal connectors causes major drawbacks to the repair and the streamlined recycling of such assemblies.

WO/2022/152560 in the name of Zhu et al., discloses a housing assembly based on polycarbonate material, of which at least the front cover and the back cover are easily recyclable due to its separability into different parts for all components which are attached to the front cover or the back cover and which cannot be recycled together with the front cover or the back cover, respectively. Snap-fits, interference-fits, predetermined breaking points and other means are used for an easily detachable, but for use safe connection of the single parts.

U.S. Pat. No. 5,808,863 issued to Radloff et al., provides a computer system, or other electronic device, having two parts that are easily attached and quickly detached. One of the parts has a plurality of stakes projecting from one surface thereof, and the other part has a plurality of through openings for receiving the stakes, and a plurality of slots extending adjacent the stakes. The stakes are formed over the other part adjacent the openings to attach the second part to the first part, and a blade can be inserted in the slots to force the second part away from the first part and break the stakes to quickly detach the parts.

To reduce or eliminate problems, therefore, a need exists in the art for laptop parts to contain a greater amount of homogenous plastic and fewer metal connectors, so they may be more quickly removed and repaired or recycled than those made according to the state of the art.

### SUMMARY OF THE INVENTION

Accordingly, the present invention reduces or eliminates problems inherent in the art by removing metal parts while maintaining laptop part integrity through intelligent design and the use of polycarbonate. As those skilled in the art are aware, polycarbonate excels in satisfying this demand given its robust property profile. The present invention minimizes the amount of metal parts in the laptop design through use of more homogenous plastic and incorporation of "breakaway features" for those metal parts that remain.

It is understood that the invention disclosed and described in this specification is not limited to the embodiments summarized in this Summary.

### BRIEF DESCRIPTION OF THE FIGURES

The present invention will now be described for purposes of illustration and not limitation in conjunction with the figures, wherein:

FIG. 1 shows an exploded view of the plastic laptop cover of the invention;

FIG. 2 illustrates an enlarged view of a top corner of the A+B assembly of the invention;

FIG. 3 depicts the electromagnetic interference (EMI) shielding material secured by a grommet on the "B" cover of the assembly of the invention;

FIG. 4 shows the electromagnetic interference (EMI) shielding material attachment to the "B" cover with a grommet;

FIG. 5 illustrates a threaded insert designed with a "break-away" feature;

FIG. 6 depicts the threaded insert of FIG. 5 being removed in the direction of the arrow;

FIG. 7A shows an alternate embodiment of the invention with a slide-in display screen and a bezel:

FIG. 7B illustrates attachment of the electromagnetic interference (EMI) shielding material to the "A" cover; and

FIG. 7C depicts the bezel cap secured with a metal screw.

## DETAILED DESCRIPTION OF THE INVENTION

The present invention will now be described for purposes of illustration and not limitation. Except in the operating examples, or where otherwise indicated, all numbers expressing quantities, percentages, and so forth in the specification are to be understood as being modified in all instances by the term "about."

Any numerical range recited in this specification is intended to include all sub-ranges of the same numerical precision subsumed within the recited range. For example, a range of "1.0 to 10.0" is intended to include all sub-ranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited in this specification is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. The various embodiments disclosed and described in this specification can comprise, consist of, or consist essentially of the features and characteristics as variously described herein.

As such, and to the extent necessary, the express disclosure as set forth in this specification supersedes any conflicting material incorporated by reference herein. Any material, or portion thereof, that is said to be incorporated by reference into this specification, but which conflicts with existing definitions, statements, or other disclosure material set forth herein, is only incorporated to the extent that no conflict arises between that incorporated material and the existing disclosure material. Applicant reserves the right to amend this specification to expressly recite any subject matter, or portion thereof, incorporated by reference herein.

Reference throughout this specification to "various non-limiting embodiments," "certain embodiments," or the like, means that a particular feature or characteristic may be included in an embodiment. Thus, use of the phrase "in various non-limiting embodiments," "in certain embodiments," or the like, in this specification does not necessarily refer to a common embodiment, and may refer to different embodiments. Further, the particular features or characteristics may be combined in any suitable manner in one or more embodiments. Thus, the particular features or characteristics illustrated or described in connection with various or certain embodiments may be combined, in whole or in part, with the features or characteristics of one or more other embodiments without limitation. Such modifications and variations are intended to be included within the scope of the present specification.

The grammatical articles "a", "an", and "the", as used herein, are intended to include "at least one" or "one or more", unless otherwise indicated, even if "at least one" or "one or more" is expressly used in certain instances. Thus, these articles are used in this specification to refer to one or more than one (i.e., to "at least one") of the grammatical objects of the article. By way of example, and without limitation, "a component" means one or more components, and thus, possibly, more than one component is contemplated and may be employed or used in an implementation of the described embodiments. Further, the use of a singular noun includes the plural, and the use of a plural noun includes the singular, unless the context of the usage requires otherwise.

The present invention reduces the amount of hardware and inserts, reduces the use of glues and adhesives in the plastic assemblies designed for a human-machine interface (HMI), which improves both the speed and ease of routine service or de-manufacturing, reduces the amount of paints and coatings needed, and relies on more homogeneous parts.

In a first embodiment, the invention is directed to a housing for a human-machine interface (HMI), comprising, a plastic assembly comprising a plastic "B" cover having one or more snap on plastic hooks protruding therefrom and one or more grooves cut therein, a display panel sandwiched into the plastic assembly behind the plastic "B" cover and in front of an electromagnetic interference (EMI) shielding material, and a plastic "A" cover having one or more grooves cut therein, wherein the plastic assembly is held together by one or more clips sliding along each side of the plastic assembly, wherein the one or more clips slide within the one or more grooves of the plastic "B" cover and one or more snap on plastic hooks and the one or more grooves of the plastic "A" cover, and wherein the electromagnetic interference (EMI) shielding material has one or more press-on grommets thereupon which are pressed onto one or more plastic buttons protruding from a surface of the plastic "A" cover to secure the electromagnetic interference (EMI) shielding material to the plastic "A" cover.

In a second embodiment, the invention is directed to a housing for a human-machine interface (HMI), comprising, a plastic assembly comprising a plastic "B" cover, a slide-in display screen, and a plastic display bezel comprising a plastic display bezel cap, with one or more grooves, cut therein and having one or more openings for a metal screw therethrough, wherein the plastic display bezel cap is secured to the plastic display bezel with one or more metal screws inserted through

the one or more openings, and wherein the plastic display bezel surrounds the slide-in display screen and plastic "B" cover, wherein an electromagnetic interference (EMI) shielding material is attached to the plastic "B" cover by one or more plastic heat stakes and wherein the electromagnetic interference (EMI) shielding mater is sandwiched between the plastic "B" cover and the slide-in display screen after sliding into the one or more grooves of the plastic display bezel.

In a third embodiment, the invention is directed to a process of recycling the housing according to one of the previous two paragraphs, the process comprising disassembling the housing, removing any non-plastic parts, mechanically shredding the housing, at least one of cleaning, sanitizing, sorting the housing, subjecting the housing to at least one of pyrolysis and chemolysis to obtain a monomer, polymerizing the monomer to produce a polymer and optionally, pelletizing the polymer.

In various embodiments, the present invention is directed to housings for a human-machine interface (HMI), such as electrical and electronic devices and appliances, particularly laptop covers, made to the greatest extent possible of thermoplastic materials. The housing is made of an assembly designed for improved sustainability because it uses less metal hardware, inserts, glues, adhesives, paints, coatings, and it includes larger homogeneous thermoplastic parts, making for easier end of life recycling. The inventive housing also is easier to disassemble for service and repair.

In certain embodiments, the assembly of the invention may include one or more slide-on clips in the form of "C" shaped channels (i.e., "C" shaped cross-section) to hold parts comprising integrated flanges tightly together, i.e., like a clamp. (e.g., allows for clamping of LCD screen non-permanently in a laptop). The clips may be made of a material such as plastic (preferably the same plastic as the housing), metal, rubber, thermoplastic polyurethane (TPU), and combinations of these materials. The assembly may take two different configurations: a clamshell with flange, or a vertically sliding with one or more set screws.

Various embodiments of the invention include break-away features for in-molded metal parts, e.g., predetermined breaking points (designed weaknesses that fail when desired or with a specific undefined tool). Certain embodiments may include one or more plastic heat-stakes to replace metal versions. Selected embodiments may include one or more press-on grommets to replace screws and promote repeated assembly/disassembly. In other embodiments, there may be a connection of same-material thermoplastic parts via welding, e.g., ultrasonic welding, laser welding, vibrational welding, infrared welding, hot plate welding. In some embodiments, intermittent welding (also referred to as "stitch weld" or "skip weld") may be used between thermoplastic parts. In various embodiments, thermal staking may be used instead of glue to fasten the electromagnetic interference (EMI) shielding material in place. Welded cover parts which allow unique disassembly benefits (i.e., sliding the joined covers over the circuit boards laterally, instead of clamshell) may be included in various embodiments of the invention.

The molded parts of the inventive assemblies are made of a molded plastic material and are preferably made of substantially the same plastic material. Preferably, each of these components comprise 50-100% the same material. In preferred embodiments, the components comprise at least 60%, at least 70%, or at least 80% the same material. In a particularly preferred embodiment, the molded parts comprise at least 90% of the same material, or even 100% the same material.

In selected embodiments the inventive assemblies are thermoplastic compositions comprising A) an aromatic polycarbonate, B) a polyether polyol and optionally, C) at least one additive selected from the group consisting of flame retardants, antidripping agents, impact modifiers, fillers, antistats, coloring agents, pigments, thermal stabilizers different from component B, lubricants, demolding agents, UV absorbers, IR absorbers, hydrolysis stabilizers, and compatibilizers.

## Component A

According to the invention, "polycarbonate" is to be understood as meaning both homopolycarbonates and copolycarbonates, in particular, polycarbonates. These polycarbonates may be linear or branched in known fashion. According to the invention, mixtures of polycarbonates may also be used.

A "polycarbonate" or a "polycarbonate material" is a thermoplastic material preferably comprising at least 50 wt.% polycarbonate, more preferably at least 60 wt.% polycarbonate, and even more preferably, at least 65 wt.% polycarbonate.

A portion of up to 80 mol%, preferably of 20 mol% to 50 mol%, of the carbonate groups in the polycarbonates used in accordance with the invention may be replaced by aromatic dicarboxylic ester groups. Polycarbonates of this kind, incorporating both acid radicals from the carbonic acid and acid radicals from aromatic dicarboxylic acids in the molecule chain, are referred to as "aromatic polyestercarbonates." In the context of the present invention, they are encompassed by the umbrella term of the thermoplastic aromatic polycarbonates. The replacement of the carbonate groups by aromatic dicarboxylic acid ester groups takes place essentially stoichiometrically and quantitatively, so that the molar ratio of the reaction partners can also be found in the finished polyestercarbonate. The incorporation of dicarboxylic acid ester groups can be statistical as well as in blocks.

In various embodiments, the thermoplastic polycarbonates, including the thermoplastic aromatic polyestercarbonates, have weight average molecular weights $M_w$, determined by gel permeation chromatography under use of $CH_2Cl_2$

as diluent, of from 10,000 g/mol to 35,000 g/mol, in certain embodiments, from 12,000 g/mol to 32,000 g/mol, in selected embodiments, from 15,000 g/ mol to 32,000 g/mol, and in particular embodiments, from 20,000 g/mol to 31,500 g/mol. The gel permeation chromatography is conducted under the following conditions: calibration with linear polycarbonate (made from bisphenol A and phosgene) of known molecular weight distribution, standards from PSS Polymer Standards Service GmbH, Germany, calibration according to method 2301-0257502-09D (from the year 2009 in German language) from Currenta GmbH & Co. OHG, Leverkusen. Diluent methylene chloride. Column combination from cross-linked styrenedivinylbenzene resin. Diameter of the analytical columns: 7.5 mm, length: 300 mm. Particle size of the column material: 3 $\mu$m to 20 $\mu$m. Concentration of the solutions: 0.2 wt.-%. Flow rate: 1.0 ml/min, temperature of the solution: 30°C. Detection by means of a refractive index (RI)-detector.

Details regarding the preparation of polycarbonates are disclosed in many patent documents spanning approximately the last 60 years. Reference may be made here to Schnell, "Chemistry and Physics of Polycarbonates". Polymer Reviews, Volume 9, Interscience Publishers, New York, London, Sydney 1964, to D. Freitag, U. Grigo, P.R. Müller, H. Nouvertné, BAYER AG, "Polycarbonates" in Encyclopedia of Polymer Science and Engineering, Volume 11, Second Edition, 1988, pages 648-718 and finally to U. Grigo, K. Kirchner and P.R. Müller "Polycarbonate" [Polycarbonates] in Becker/Braun, Kunststoff-Handbuch [Plastics Handbook], volume 3/1, Polycarbonate, Polyacetale, Polyester, Celluloseester [Polycarbonates, Polyacetals, Polyesters, Cellulose Esters], Carl Hanser Verlag Munich, Vienna 1992, pages 117-299.

Various processes for the production of the polycarbonates which are useful in the present invention, including polyestercarbonates, are the interfacial process and the melt transesterification process (e.g., U.S. Pat. Nos. 5,097,002; 5,340,905; 5,717,057; 6,596,840; 6,740,730; and 7,071,284).

Aromatic polycarbonates are prepared, for example, by reaction of dihydroxyaryl compounds with carbonyl halides, preferably phosgene, and/or with aromatic dicarbonyl dihalides, preferably benzenedicarbonyl dihalides, by the interfacial process, optionally with use of chain terminators and optionally with use of trifunctional or more than trifunctional branching agents, wherein for the production of polyestercarbonates a part of the carbonic acid derivatives is replaced with aromatic dicarboxylic acids or derivatives of dicarboxylic acids, namely according to the carbonate structure units in the aromatic polycarbonates by dicarboxylic acid ester structure units. Preparation via a melt polymerization process by reaction of dihydroxyaryl compounds with, for example, diphenyl carbonate is likewise possible.

Dihydroxyaryl compounds suitable for the preparation of polycarbonates are those of the formula (1)

$$HO\text{-}Z\text{-}OH \qquad (1),$$

wherein,

Z is an aromatic radical of 6 to 30 carbon atoms which may contain one or more aromatic rings, may be substituted and may contain aliphatic, cycloaliphatic radicals, alkylaryl groups, or heteroatoms as bridging elements.

Preferably, Z in formula (1) is a radical of the formula (2)

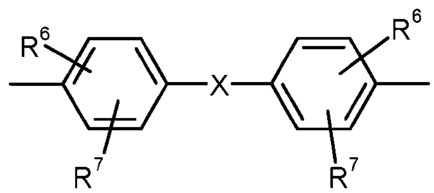

(2),

wherein

$R^6$ and $R^7$ are each independently H, $C_1$-$C_{18}$-alkyl-, $C_1$-$C_{18}$-alkoxy, halogen such as Cl or Br or in each case optionally substituted aryl or aralkyl, in some embodiments H or $C_1$-$C_{12}$-alkyl, in certain embodiments H or $C_1$-$C_8$-alkyl and in selected embodiments H or methyl, and

X is a single bond, $-SO_2-$, -CO-, -O-, -S-, $C_1$-$C_6$-alkylene, $C_2$-$C_5$-alkylidene or $C_5$-$C_6$-cycloalkylidene which may be substituted by $C_1$-$C_6$-alkyl, preferably methyl or ethyl, or else $C_6$-$C_{12}$-arylene which may optionally be fused to further aromatic rings containing heteroatoms.

In various embodiments, X is a single bond, $C_1$-$C_5$-alkylene, $C_2$-$C_5$-alkylidene, $C_5$-$C_6$-cycloalkylidene, -O-, -SO-, -CO-, -S-, $-SO_2-$ or a radical of the formula (2a)

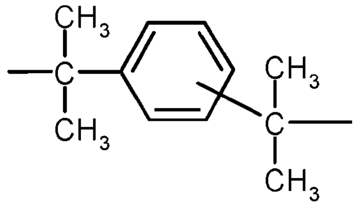

(2a).

Examples of dihydroxyaryl compounds suitable for the preparation of the polycarbonates for use in accordance with the invention include, but are not limited to, hydroquinone, resorcinol, dihydroxydiphenyl, bis(hydroxyphenyl)alkanes, bis(hydroxyphenyl)cycloalkanes, bis(hydroxyphenyl) sulphides, bis(hydroxyphenyl) ethers, bis(hydroxyphenyl) ketones, bis(hydroxyphenyl) sulphones, bis(hydroxyphenyl) sulphoxides, $\alpha,\alpha'$-bis(hydroxyphenyl)diisopropylbenzenes and the alkylated, ring-alkylated and ring-halogenated compounds thereof.

Useful dihydroxyaryl compounds are 4,4'-dihydroxydiphenyl, 2,2-bis(4-hydroxyphenyl)propane (bisphenol A), 2,4-bis(4-hydroxyphenyl)-2-methylbutane, dimethyl-bisphenol A, 1,1-bis(4-hydroxyphenyl)-p-diisopropylbenzene, 2,2-bis(3-methyl-4-hydroxyphenyl)propane, 2,2-bis(3-methyl-4-hydroxyphenyl)propane, bis(3,5-dimethyl-4-hydroxyphenyl) methane, 2,2-bis(3,5-dimethyl-4-hydroxyphenyl)propane, bis(3,5-dimethyl-4-hydroxyphenyl)sulfone, 2,4-bis(3,5-dimethyl-4-hydroxyphenyl)-2-methylbutane, 1,1-bis(3,5-dimethyl-4-hydroxyphenyl)-p-diisopropylbenzene and 1,1-bis(4-hydroxyphenyl)-3,3,5-trimethylcyclohexane, and bisphenols (I) to (III)

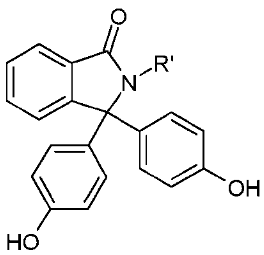

(I)

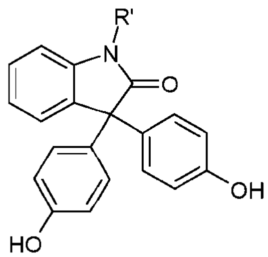

(II)

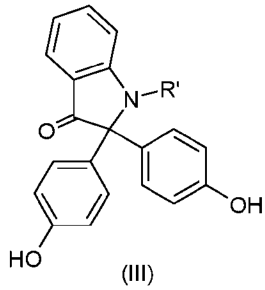

(III)

,

R' in each case is $C_1$-$C_4$-alkyl, aralkyl or aryl, in certain embodiments, methyl or phenyl, in selected embodiments, methyl.

In certain embodiments, the dihydroxyaryl compounds include 2,2-bis-(4-hydroxyphenyl)-propane (bisphenol A), 2,2-bis(3,5-dimethyl-4-hydroxyphenyl)propane, 1,1-bis(4-hydroxyphenyl)cyclohexane and 1,1-bis(4-hydroxyphenyl)-3,3,5-trimethylcyclohexane (bisphenol TMC) and dimethyl-bisphenol A as well as the dihydroxyaryl compounds of formula (I), (II) and (III).

These and further suitable dihydroxyaryl compounds are described, for example, in U.S. Pat. Nos. 2,991,273; 2,999,835; 2,999,846; 3,148,172; 3,271,367; 4,982,014; DE 2 036 052 A, and DE 3 832 396 A; in French patent application 1 561 518 A1; GB1122003; GB1229482; GB1341318; GB1367790; in the monograph, H. Schnell, Chemistry and Physics of Polycarbonates, Interscience Publishers, New York 1964, p. 28 ff.; p. 102 ff., and in D.G. Legrand, J.T. Bendler, Handbook of Polycarbonate Science and Technology, Marcel Dekker New York 2000, p. 72ff.

Only one dihydroxyaryl compound is used in the case of the homopolycarbonates; two or more dihydroxyaryl compounds are used in the case of copolycarbonates. The dihydroxyaryl compounds employed, as well as components of the compositions used in accordance with the invention, similarly to all other chemicals and assistants added to the synthesis, may be contaminated with the contaminants from their own synthesis, handling, and storage. However, it is desirable to employ the purest possible raw materials.

Examples of suitable carbonic acid derivatives include phosgene and diphenyl carbonate.

Suitable chain terminators useful in the production of polycarbonates are monophenols. Suitable monophenols include, for example, phenol itself, alkylphenols such as cresols, p-tert-butylphenol, cumylphenol, and mixtures thereof.

In various embodiments, chain terminators include phenols mono- or polysubstituted by linear or branched $C_1$-$C_{30}$-alkyl radicals, unsubstituted or substituted by tert-butyl. In selected embodiments, the chain terminators are phenol, cumylphenol and p-tert-butylphenol. The amount of chain terminator to be used may be 0.1 to 5 mol%, based on moles of dihydroxyaryl compounds used in each case. The chain terminators can be added before, during or after the reaction with a carbonic acid derivative.

Suitable branching agents include trifunctional or more than trifunctional compounds familiar in polycarbonate chemistry, particularly those having three or more than three phenolic OH groups. Examples of suitable branching agents include, but are not limited to, 1,3,5-tri(4-hydroxyphenyl)benzene, 1,1, 1-tri(4-hydroxyphenyl)ethane, tri(4-hydroxyphenyl)phenylmethane, 2,4-bis(4-hydroxyphenylisopropyl)phenol, 2,6-bis(2-hydroxy-5'-methylbenzyl)-4-methylphenol,

2-(4-hydroxyphenyl)-2-(2,4-dihydroxyphenyl)propane, tetra(4-hydroxyphenyl)methane, tetra(4-(4-hydroxyphenylisopropyl)phenoxy)methane and 1,4-bis((4',4"-dihydroxytriphenyl)methyl)benzene and 3,3-bis(3-methyl-4-hydroxyphenyl)-2-oxo-2,3-dihydroindole. The amount of any branching agents to be used may be 0.05 mol% to 2 mol%, based on moles of dihydroxy aryl compounds used in each case. The branching agents can either be initially charged together with the dihydroxyaryl compounds and the chain terminators in the aqueous alkaline phase or added dissolved in an organic solvent before the phosgenation. In the case of the transesterification process, the branching agents are used together with the dihydroxyaryl compounds.

In various embodiments, the polycarbonates are homopolycarbonate based on bisphenol A, homopolycarbonate based on 1,3-bis(4-hydroxyphenyl)-3,3,5-trimethylcyclohexane and copolycarbonates based on the two monomers bisphenol A and 1,1-bis(4-hydroxyphenyl)-3,3,5-trimethylcyclohexane, and homo- or copolycarbonates derived from the dihydroxyaryl compounds of the formulae (I) to (III),

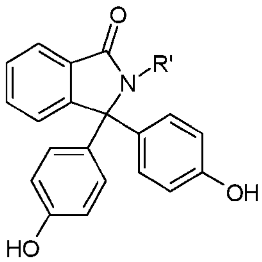
(I)

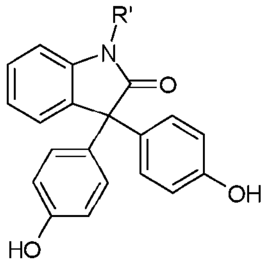
(II)

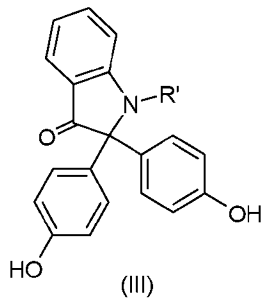
(III)

,

wherein R' in each case is $C_1$-$C_4$-alkyl, aralkyl or aryl, in certain embodiments methyl or phenyl, in selected embodiments methyl, and in particular embodiments with bisphenol A as comonomer.

To facilitate incorporation of additives, component A may be used in the form of powders, pellets, or mixtures thereof.

In various embodiments, the polycarbonate has an MVR of from 4.5 to 34 $cm^3$/(10 min), in certain embodiments of from 5.5 to 12 $cm^3$/(10 min), in selected embodiments of from 6 to 10 $cm^3$/(10 min), determined according to ISO 1133:2012-03 at a test temperature of 300 °C and 1.2 kg load.

A mixture of different polycarbonates may be used as component A, for example a mixture of the polycarbonates A1 and A2, wherein A2 is a polycarbonate in powdered form. As used herein, the properties for the polycarbonate refer to a respective mixture.

In various embodiments, the compositions contain 50 to 98.5 wt.%, in some embodiments, 69.85 to 98.0 wt.%, in certain embodiments 85 to 97.5 wt.%, in selected embodiments 90.0 to 97.5 wt.%, and in particular embodiments, 93.0 wt.% to 97.5 wt.% of the aromatic polycarbonate.

## Component B

Component B comprises one or more stabilizers in the form of a polyether polyol. As those skilled in the art are aware, polyether polyols are the product of the polymerization of epoxides, such as ethylene oxide (EO), propylene oxide (PO), butylene oxide, styrene oxide, and epichlorohydrin, with themselves or by addition of such epoxides, optionally in admixture or sequentially, to starting components with reactive hydrogen atoms, such as water, alcohol, ammonia or amines. Such "starter molecules" usually have a functionality of from 1 to 6. Depending on the process control, such polyether polyols may be homopolymers, block copolymers, random copolymers, capped polymers, or polymers tipped with a mixture of different epoxides.

To specify such polyether polyols, various characteristics have become established in the art:

i) hydroxyl functionality, which depends on the starter molecule starting from which the polyether polyol is synthesized,
ii) hydroxyl or OH number, which is a measure of the content of hydroxyl groups stated in mg of KOH/g, determined according to DIN 53240-3:2016-03,
iii) when epoxides in which the ring opening causes the formation of different, i.e., primary or secondary) hydroxyl groups are used, on the one hand, the proportion of the respective epoxides in the polyether polyol is stated, and on the other hand, the proportion of primary or secondary hydroxyl groups based on the total number of hydroxyl groups present in the polyether polyol is stated, and
iv) the molecular weight ($M_n$ or $M_w$), which is a measure of the length of the polyoxyalkylene chains of the polyether polyols.

In various embodiments, polyether polyols have a number average molecular weight $M_n$ of from 100 to 6200 g/mol, in certain embodiments from 1500 to 4000 g/mol, and in selected embodiments from 1800 to 3000 g/mol, where. $M_n$ is calculated according to the following formula:

$$M_n = 56100*F/OHN.$$

OH-number (OHN) is determined via hydroxyl end group titration according to DIN 53240-3:2016-03. OHN in mg KOH/g is inserted in the given formula. F is the functionality, which in the context of this invention related to hydroxyl end groups. Acid end groups, if any, are not taken into account. F is defined as number of hydroxyl end groups, divided by the number of molecules in an ensemble, meaning F is the average number of hydroxyl end groups of a molecule of a compound. F is normally apparent from the recipe for preparing the polyol but may alternatively be determined by $^1$H NMR.

In various embodiments, the polyether polyols may be formed from repeating ethylene oxide and propylene oxide units, e.g., with a share of 35 to 100 wt.% propylene oxide units, in certain embodiments 50 to 100 wt.% propylene oxide units. The copolymers may be statistical copolymers, gradient copolymers, alternating copolymers or block copolymers formed from ethylene oxide and propylene oxide. In selected embodiments, the polyether polyols are linear polymers.

Useful polyether polyols are those formed from repeating propylene oxide units with a 1,2-diol as starter molecule, more preferably with propylene glycol as the starter molecule. The polyether polyols may be end-capped. In selected embodiments, the polyether polyol is end capped. A preferred agent for end-capping is dihydropyran (3,4-dihydro-2H-pyran).

Suitable polyether polyols, formed from repeating propylene oxide and/or ethylene oxide units are, e.g., DESMOPHEN, ACCLAIM, ARCOL, BAYCOLL, BAYFILL, BAYFLEX, BAYGAL, PET, POLYETHER polyols from Covestro Deutschland AG (for example DESMOPHEN 3600Z, DESMOPHEN 1900U, ACCLAIM Polyol 2200, ACCLAIM Polyol 40001, ARCOL Polyol 1004, ARCOL Polyol 1010, ARCOL Polyol 1030, ARCOL Polyol 1070, BAYCOLL BD 1110, BAYFILL VPPU 0789, BAYGAL K55, PET 1004, POLYETHER S180). Further suitable homo-polyethylene oxides are, for example, the PLURIOL E polyols from BASF SE. Suitable homo-propylene oxides are, for example, PLURIOL P polyols from BASF SE or MULTRANOL polyols from Covestro Deutschland AG, SYNALOX polyols from The Dow Chemical Company and CARADOL polyols from Shell Chemicals. Suitable mixed copolymers formed from ethylene oxide and propylene oxide are, for example, the PLURONIC PE or PLURIOL RPE polyols from BASF SE.

In certain embodiments, the polyether polyols may be those formed from repeating propylene oxide units with propylene glycol as starter molecule, an OH number within a range of from 50 to 70 mg KOH/g determined according to DIN 53240-3:2016-03, and having a hydroxyl functionality of 2, a proportion of primary hydroxyl groups within a range of from 0 to 3%, based on the total number of primary and secondary hydroxyl groups, having a propylene oxide content of at least 95 wt.% and ethylene oxide content of up to 3 wt.%, in selected embodiments, those without any ethylene oxide units, but only with propylene oxide units.

The compositions useful with the invention may comprise polyether polyols in various embodiments in an amount of from 0.1 to 5 wt.%, in certain embodiments, 0.1 wt.% to 2 wt.%, in selected embodiments, 0.5 wt.% to 1 wt.%, and in particular embodiments, 0.5 wt.% to 1.0 wt.%, wherein wt.% refers to the weight of the composition.

## Component C

The compositions useful in the invention optionally may comprise additives known to those in the art, including, but not limited to, flame retardants, antidripping agents, impact modifiers, fillers, antistats, coloring agents, pigments, thermal stabilizers different from component B, lubricants, demolding agents, UV absorbers, IR absorbers, hydrolysis stabilizers, and compatibilizers.

Such additives as typically added in the case of polycarbonates are described, e.g., in U.S. Pat. Nos. 5,288,778; 5,821,380; and 5,883,165 and in "Plastics Additives Handbook", Hans Zweifel, 5th Edition 2000, Hanser Verlag, Munich.

The amount of such additives in various embodiments is up to 30 wt.%, in some embodiments up to 10 wt.%, in certain embodiments up to 6 wt.%, in selected embodiments 0.01 to 3 wt.%, and in particular embodiments 1 wt.%, with all values referring to the composition and all including the upper value.

Useful demolding agents include, but are not limited to, pentaerythrityl tetrastearate (PETS), glycerine monostearate (GMS), their carbonates, and mixtures of any of these.

In various embodiments, up to 0.1 wt.%, in certain embodiments, 0.0001 wt.% to 0.001 wt.%, in selected embodiments, 0.0004 wt.% to 0.001 wt.%, of one or more coloring agents are used as additive. The amount "to 0.001 wt.% of one or more coloring agents" means that up to 0.001 wt.% (inclusive) of coloring agents in total are included. In a mixture of two or more coloring agents, the upper limit for the mixture of coloring agents is 0.001 wt %. Coloring agents may be included to improve the visual impression if it is intended to compensate for a minimum discoloration after irradiation, if present. It is however also possible to use compositions without any coloring agents. It is also possible to use even more coloring agents.

Coloring agents or pigments useful in the context of the present invention include, e.g. sulfur-containing pigments as cadmium red or cadmium yellow, iron cyanide-based pigments as Prussian Blue, oxide pigments as titan dioxide, zinc oxide, red iron oxide, black iron oxide, chromium oxide, titanium yellow, zinc-iron-based brown, titan-cobalt-based green, cobalt blue, copper-chromium-based black, copper-iron-based black or chromium-based pigments as chromium yellow, phthalocyanine-based coloring agents as copper-phthalocyanine blue or copper-phthalocyanine green, condensed polycyclic coloring agents and pigments as azo-based ones (for example nickel-azo-yellow), sulfur-indigo coloring agents, perinone-based, perylene-based, quinacridone-based, dioxazine-based, isoindolinone-based, and quinophthalone-based derivatives, anthraquinone-based, heterocyclic systems.

Specific examples for coloring agents include, but are not limited to, commercial products as MACROLEX Blue RR, MACROLEX Violet 3R, MACROLEX Red EG, MACROLEX Violet B (Lanxess AG, Germany), SUMIPLAST Violet RR, SUMIPLAST Violet B, SUMIPLAST Blue OR, (Sumitomo Chemical Co., Ltd.), DIARESIN Violet D. DIARESIN Blue G, DIARESIN Blue N (Mitsubishi Chemical Corporation), HELIOGEN Blue and HELIOGEN Green (BASF AG, Germany). Further suitable coloring agents are, e.g., AMAPLAST Yellow GHS (CAS 13676-91-0; SOLVENT YELLOW 163; C.I. 58840); KEYPLAST Blue KR (CAS 116-75-6; SOLVENT BLUE 104; C.I. 61568), HELIOGEN BLUE types (e.g., HELIOGEN BLUE K 6911; CAS 147-14-8; PIGMENT BLUE 15:1; C.I. 74160) as well as HELIOGEN GREEN types (as e.g. HELIOGEN GREEN K 8730; CAS 1328-53-6; PIGMENT GREEN 7; C.I. 74260). Cyanine-, quinolone-, anthraquinone-, phthalocyanine-derivatives may be particularly useful.

Suitable pigments include, but are not limited to, titan dioxide, talc, wollastonite, and mica. Carbon black may be a suitable pigment in various embodiments, although, where carbon black is used, the amount is very low, i.e., only up to < 0.1 wt.%, to avoid any effect of coloring by carbon black.

In certain embodiments, compositions may be used that contain blue and/or violet coloring agents to partially compensate for the visual yellow color impression which is a consequence of damage by irradiation. In combination with the stabilizer combination, this gives the least colored ready-to-use articles.

Optionally, the composition may comprise a UV absorber. Various UV absorbers are those having as low a transmission as possible below 400 nm and as high a transmission as possible above 400 nm. Such UV absorbers are known in the art and described, e.g., in U.S. Pat. Nos. 5,288,778; 5,821,380; and 5,883,165. Ultraviolet absorbers particularly suitable for use in the composition according to the invention are selected from benzotriazoles, triazines, benzophenones, and arylated cyanoacrylates.

Particularly suitable ultraviolet absorbers are hydroxybenzotriazoles, such as 2-(3',5'-bis(1,1-dimethylbenzyl)-2'-hydroxyphenyl)benzotriazole (TINUVIN 234, BASF), 2-(2'-hydroxy-5'-(tert-octyl)phenyl)benzotriazole (TINUVIN 329, BASF), bis(3-(2H-benzotriazolyl)-2-hydroxy-5-tert-octyl)methane (TINUVIN 360, BASF), 2-(4,6-diphenyl-1,3,5-triazin-2-yl)-5-(hexyloxy)phenol (TINUVIN 1577, BASF), and also benzophenones such as 2,4-dihydroxybenzophenone (CHIMASSORB 22, BASF) and 2-hydroxy-4-(octyloxy)benzophenone (CHIMASSORB 81, BASF), 2,2-bis[[(2-cyano-1-oxo-3,3-diphenyl-2-propenyl)oxy]methyl]-1,3-propanediyl ester (9CI) (UVINUL 3030, BASF AG), 2-[2-hydroxy-4-(2-ethylhexyl)oxy]phenyl-4,6-di(4-phenyl)phenyl-1,3,5-triazine (TINUVIN 1600, BASF,), tetraethyl-2,2'-(1,4-phenylenedimethylidene) bismalonate (HOSTAVIN B-Cap, Clariant) or N-(2-ethoxyphenyl)-N'-(2-ethylphenyl)ethanediamide (TINUVIN 312, CAS No. 23949-66-8, BASF). Particularly preferred specific UV absorbers are TINUVIN 360, TINUVIN 329 and/or TINUVIN 312, very particular preference being given to TINUVIN 329 and TINUVIN 312. It is also possible to employ mixtures of these ultraviolet absorbers.

Suitable IR absorbers are described, in a variety of patents including U.S. Pat. Nos. 7,074,351; 7,169,834; 8,153,239; and in U.S. Pat. Pub. 2005/0165148. Of those mentioned in the literature, boride- and/or tungstate-based IR absorbers, in particular, cesium tungstate or zinc-doped cesium tungstate, as well as ITO- or ATO-based IR absorbers and combinations thereof are particularly useful.

Suitable impact modifiers are core-shell type impact modifiers, including, but not limited to, acrylonitrile butadiene styrene (ABS), copolymer of methyl methacrylate, acrylonitrile, butadiene and styrene (MBS), acryl-based, silicone-acryl-based impact modifiers, and non-core-shell type impact modifiers.

The polycarbonate compositions useful according to the invention may comprise organic and inorganic fillers in the usual amounts. Suitable fillers include, but are not limited to, glass fibers and carbon fibers, cellulosics, graphite, graphene, and carbon nanotubes, chalk, quartz powder, titanium dioxide, silicates, aluminosilicates, e.g., talc, wollastonite, montmorillonite, also modified by ion exchange, kaolin, zeolite, vermiculite, aluminium oxide, and silica. Mixtures of these or these and other fillers may also be used.

Polytetrafluoroethylene may be used as an antidripping agent.

Sulfur-containing stabilizers may be used including, but not limited to, 3,3'-thiodipropionic, distearyl disulfide (HOSTANOX SE 10, Clariant), pentaerythrityl tetrakis(3-laurylthiopropionate) (SOGNOX 4120, Songwon International AG) and bis-(phenylsulfonyl)methane.

The polymer compositions useful in the invention, comprising components A, B, and optionally C, are produced by standard incorporation processes via combination, mixing and homogenization of the individual constituents, especially with the homogenization taking place in the melt under the action of shear forces. If appropriate, combination

and mixing prior to the melt homogenization occurs using powder premixes. For all components used, it is desirable to employ the purest possible compounds.

Various embodiments may use premixes of granules or granules and powders with components B and optionally C. Other embodiments may use premixes which have been produced from solutions of the mixture components in suitable solvents, in which case homogenization is optionally effected in solution and the solvent is removed.

It is possible to introduce components B and optionally C into the polycarbonate by known methods or as a masterbatch. Masterbatches may be used in selected embodiments for incorporation of component C.

In this context, the composition useful in the invention may be combined, mixed, homogenized and subsequently extruded in customary apparatus such as screw extruders (TSE twin-screw extruders for example), kneaders or BRABENDER or BANBURY mills. In these embodiments, the extrudate may be cooled and comminuted after extrusion. It is also possible to premix individual components and to add the remaining starting materials individually and/or likewise in a mixture.

It is possible in various embodiments to combine and mix a premix in the melt in the plastifying unit of an injection-molding machine. In these embodiments, the melt is converted directly to a shaped body in the subsequent step.

The manufacture of the molded parts from the compositions according to the invention in various embodiments may be accomplished by injection-molding, extrusion, or rapid-heat cycle molding.

Such compositions are useful for the manufacture of injection-molded parts or extrudates for a human-machine interface (HMI). Injection-molded parts and extrudates are understood as being molded polycarbonate assemblies such as the laptop covers exemplified in this Specification. The assemblies of the invention preferably are made of homogenous polycarbonate to facilitate efficient recycling. The invention also includes housing assemblies for a human-machine interface (HMI) such as a laptop computer, a tablet computer, a notebook computer, a desktop computer, a television, a gaming device, an advertising display, a battery, a monitor, a camera, a server, an access control, point of sale equipment, an e-reader, a projector, a thermostat, a home automation portal, a kitchen appliance, an automotive part, a healthcare device, a surgical device, a smart hub, a mobile phone, a GPS receiver, a transceiver, a remote control, a head lamp, control electronics, a router -WLAN or LAN, a wired or wireless access point, and an electrical power source. Such devices comprising a housing according to the invention, including the preferred embodiments, are also subject matter of the invention.

As those skilled in the art are aware, various processes exist for recycling plastic materials, such as polycarbonates. Such processes may involve disassembling the housing, removing any non-plastic parts (such as the display panel, electromagnetic interference EMI shielding material, metal screws, etc.), mechanically shredding the housing, at least one of cleaning, sanitizing, and sorting the housing followed by the addition of heat (pyrolysis), and/or by the addition of chemical agents (chemolysis) to obtain a monomer, polymerizing the monomer to produce a polymer, and optionally, pelletizing the polymer.

Although described herein in the context of a plastic laptop housing, the invention is not intended to be so limited. The present invention is applicable to a plastic housing for any human-machine interface (HMI), such as those listed herein, and others not here listed.

An exploded view of one embodiment of a plastic laptop housing of the invention is provided in FIG. 1. As shown in FIG. 1, the plastic assembly **10** comprises a plastic "B" cover **12** having one or more snap on plastic hooks **14** protruding therefrom and one or more grooves **16** cut therein. Display panel **18** is sandwiched into the assembly **10** behind plastic "B" cover **12** and in front of electromagnetic interference (EMI) shielding material **20** and plastic "A" cover **22.** The housing assembly is held together by a "C" shaped sliding clip **24** along each side of the assembly. The "C" shaped or "U" shaped sliding clips **24** slide within the grooves **16** of plastic "B" cover and snap on to plastic hooks **14** and grooves **16** of plastic "A" cover. This reduces or eliminates the need for metal screws or adhesive tape to hold the housing assembly tightly together. Electromagnetic interference (EMI) shielding **20** has press-on grommets **26** thereupon which are pressed onto plastic buttons **28** protruding from the surface of plastic "A" cover **22** to help secure electromagnetic interference (EMI) shielding **20** to the "A" cover **22,** again reducing or eliminating the need for adhesives. Plastic "A" cover **22** optionally has one or more plastic snaps **30** thereon to help provide support to the housing assembly **10** and to secure the display panel **18.**

Display panels and screens are available in a variety of types for laptops and devices such as tablet computers and smartphones. These types include TN (twisted nematic) panels, VA (vertical alignment) panels, LCD (liquid crystal displays), TFT (thin film transistors), IPS (in-plane switching), PLS (plane to line switching), AMOLED (active matrix organic light-emitting diodes), OLED (organic light emitting diodes), and P-OLEDs (passive matrix OLEDs).

Electromagnetic interference (EMI) shielding materials include metals, conducting plastics and conducting polymers. Such materials are commercially available as films, foils, tapes, and sheets, and are described, e.g., in U.S. Pat. Nos. 9,167,735; 9,505,903; 8,722,186; 8,691,393; and 8,222,321.

FIG. 2 depicts an enlarged view of a corner of the housing assembly **100** showing plastic "B" cover **112,** display panel **118,** and plastic "A" cover **122** sandwiched and held together with a "C" shaped or "U" shaped sliding clip **124** engaging with grooves **116.** As can be appreciated by reference to FIG. 2, this arrangement may greatly reduce or eliminate altogether the need for tape or screws to hold the housing assembly together.

FIG. 3 shows electromagnetic interference (EMI) shielding material **220** secured by a grommet **226** onto a button **228** of plastic "A" cover **222** of the housing assembly of the invention. The electromagnetic interference (EMI) shielding material preferably has a number of grommets, and plastic "A" cover has an equal number of buttons to facilitate securing the shielding.

FIG. 4 shows grommet **326** of electromagnetic interference (EMI) shielding material **320** being pushed in the direction of the block white arrow onto button **328** on plastic "A" cover **322** of the housing assembly of the invention.

FIG. 5 illustrates a threaded metal insert **440** designed with a "break-away" feature for rapid disassembly. The break-away feature may comprise one or more notches **442** cut into the base of the plastic part so that the plastic encased metal boss may be easily fractured and removed, and the remainder of the part can be recycled.

FIG. 6 depicts threaded metal insert **440** of FIG. 5 being removed in the direction of the block white arrow as the notches provide a built-in weakness to fracture the insert.

FIG. 7A shows another embodiment of the invention with a slide-in display screen **500** and a plastic display bezel **510** with grooves cut in it. This embodiment of the invention holds the slide-in display screen **500** securely while reducing or eliminating the need for hardware, foam, and adhesives.

FIG. 7B illustrates attachment of the electromagnetic interference (EMI) shielding material **520** to plastic "B" cover by one or more plastic heat stakes **525,** eliminating the need for adhesives and allowing for easier removal of the electromagnetic interference (EMI) shielding material **520** prior to recycling the plastic.

FIG. 7C depicts a closer view of the display plastic bezel cap **512** secured to plastic display bezel **510** with a metal screw **535** thereby reducing both hardware use and disassembly time. The metal screw **535** allows for easy removal of the slide-in display screen 500 for repair or recycling.

This specification has been written with reference to various non-limiting and non-exhaustive embodiments. However, it will be recognized by persons having ordinary skill in the art that various substitutions, modifications, or combinations of any of the disclosed embodiments (or portions thereof) may be made within the scope of this specification. Thus, it is contemplated and understood that this specification supports additional embodiments not expressly set forth herein. Such embodiments may be obtained, for example, by combining, modifying, or reorganizing any of the disclosed steps, components, elements, features, aspects, characteristics, limitations, and the like, of the various non-limiting embodiments described in this specification.

## Claims

**1.** A housing for a human-machine interface HMI, comprising:

> a plastic assembly (10) comprising a plastic "B" cover (12) having one or more snap on plastic hooks (14) protruding therefrom and one or more grooves (16) cut therein;
> a display panel (18) sandwiched into the plastic assembly (10) behind the plastic "B" cover (12) and in front of an electromagnetic interference EMI shielding material (20); and
> a plastic "A" cover (22) having one or more grooves (16) cut therein,
> wherein the plastic assembly (10) is held together by one or more clips (24) sliding along each side of the plastic assembly (10),
> wherein the one or more clips (24) slide within the one or more grooves (16) of the plastic "B" cover (12) and one or more snap on plastic hooks (14) and the one or more grooves (16) of the plastic "A" cover, and
> wherein the electromagnetic interference EMI shielding material (20) has one or more press-on grommets (26) thereupon which are pressed onto one or more plastic buttons (28) protruding from a surface of the plastic "A" cover (22) to secure the electromagnetic interference EMI shielding material (20) to the plastic "A" cover (22).

**2.** The housing according to claim 1, wherein the plastic "B" cover (12) has one or more plastic snaps (30) thereon.

**3.** The housing according to one of claims 1 and 2, wherein the one or more clips (24) are "C" shaped or "U" shaped.

**4.** The housing according to any one of claims 1 to 3, wherein the one or more clips (24) comprise a material selected from the group consisting of plastic, metal, rubber, thermoplastic polyurethane TPU, and combinations of these materials.

**5.** The housing according to any one of claims 1 to 4, wherein the plastic comprises a thermoplastic.

**6.** The housing according to any one of claims 1 to 5, wherein the plastic comprises polycarbonate.

**7.** The housing according to claim 6, wherein the polycarbonate contains a filler selected from the group consisting of

glass fibers, carbon fibers, cellulosics, graphite, graphene, carbon nanotubes, chalk, quartz powder, titanium dioxide, silicates, talc, wollastonite, montmorillonite, kaolin, zeolite, vermiculite, aluminium oxide, silica, and mixtures of these.

**8.** The housing according to any one of claims 1 to 7, wherein the electromagnetic interference EMI shielding material (20) is selected from the group consisting of metals, conducting plastics, and conducting polymers.

**9.** The housing according to any one of claims 1 to 8, wherein the human-machine interface HMI is included in one selected from the group consisting of a laptop computer, a tablet computer, a notebook computer, a desktop computer, a television, a gaming device, an advertising display, a battery, a monitor, a camera, a server, an access control, point of sale equipment, an e-reader, a projector, a thermostat, a home automation portal, a kitchen appliance, an automotive part, a healthcare device, a surgical device, a smart hub, a mobile phone, a GPS receiver, a transceiver, a remote control, a head lamp, control electronics, a router -WLAN or LAN, a wired or wireless access point, and an electrical power source.

**10.** A housing for a human-machine interface HMI, comprising:

a plastic assembly comprising a plastic "B" cover;
a slide-in display screen (500); and
a plastic display bezel (510) comprising a plastic display bezel cap (512), with one or more grooves, cut therein and having one or more openings for a metal screw (535) therethrough,
wherein the plastic display bezel cap is secured to the plastic display bezel (510) with one or more metal screws (535) inserted through the one or more openings, and
wherein the plastic display bezel (510) surrounds the slide-in display screen (500) and plastic "B" cover, wherein an electromagnetic interference EMI shielding material 520 is attached to the plastic "B" cover by one or more plastic heat stakes (525) and wherein the electromagnetic interference EMI shielding material (520) is sandwiched between the plastic "B" cover and the slide-in display screen (500) after sliding into the one of more grooves of the plastic display bezel (510).

**11.** The housing according to claim 10, wherein the plastic comprises a thermoplastic, wherein the thermoplastic comprises polycarbonate.

**12.** The housing according to claim 11, wherein the polycarbonate contains a filler selected from the group consisting of glass fibers, carbon fibers, cellulosics, graphite, graphene, carbon nanotubes, chalk, quartz powder, titanium dioxide, silicates, talc, wollastonite, montmorillonite, kaolin, zeolite, vermiculite, aluminium oxide, silica, and mixtures of these.

**13.** The housing according to any one of claims 10 to 12, wherein the electromagnetic interference EMI shielding material (520) contains at least one selected from the group consisting of metals, conducting plastics, and conducting polymers.

**14.** The housing according to any one of claims 10 to 13, wherein the human-machine interface HMI is included in one selected from the group consisting of a laptop computer, a tablet computer, a notebook computer, a desktop computer, a television, a gaming device, an advertising display, a battery, a monitor, a camera, a server, an access control, point of sale equipment, an e-reader, a projector, a thermostat, a home automation portal, a kitchen appliance, an automotive part, a healthcare device, a surgical device, a smart hub, a mobile phone, a GPS receiver, a transceiver, a remote control, a head lamp, control electronics, a router -WLAN or LAN, a wired or wireless access point, and an electrical power source.

**15.** A process of recycling the housing according to any one of claims 1 to 14, the process comprising:

(a) disassembling the housing;
(b) removing any non-plastic part;
(c) mechanically shredding the housing;
(d) at least one of cleaning, sanitizing, and sorting the housing;
(e) subjecting the housing to at least one of pyrolysis and chemolysis to obtain a monomer;
(f) polymerizing the monomer to produce a polymer, and
(g) optionally, pelletizing the polymer.

**Patentansprüche**

1. Gehäuse für eine Mensch-Maschine-Schnittstelle (MMS), umfassend:

   eine Kunststoffbaugruppe (10), die eine Kunststoff-B-Abdeckung (12) mit einem oder mehreren davon vorstehenden Kunststoffschnapphaken (14) und einer oder mehreren darin eingeschnittenen Nuten (16) umfasst,
   ein Bildschirmmodul (18), das hinter der Kunststoff-B-Abdeckung (12) und vor einem Material zur Abschirmung gegen elektromagnetische Interferenzen (EMI) (20) in die Kunststoffbaugruppe (10) eingeschoben ist, und
   eine Kunststoff-A-Abdeckung (22) mit einer oder mehreren darin eingeschnittenen Nuten (16),
   wobei die Kunststoffbaugruppe (10) durch einen oder mehrere Clips (24) zusammengehalten wird, die entlang jeder Seite der Kunststoffbaugruppe (10) gleiten,
   wobei der eine oder die mehreren Clips (24) innerhalb der einen oder den mehreren Nuten (16) der Kunststoff-B-Abdeckung (12) gleiten und ein oder mehrere Kunststoffschnapphaken (14) in der einen oder den mehreren Nuten (16) der Kunststoff-A-Abdeckung, und
   wobei das Material zur Abschirmung gegen elektromagnetische Interferenzen (EMI) (20) eine oder mehrere Aufpressösen (26) darauf aufweist, die auf einen oder mehrere Kunststoffknöpfe (28) gepresst werden, die von einer Oberfläche der Kunststoff-A-Abdeckung (22) vorstehen, um das Material zur Abschirmung gegen elektromagnetische Interferenzen (EMI) (20) an der Kunststoff-A-Abdeckung (22) zu befestigen.

2. Gehäuse nach Anspruch 1, wobei die Kunststoff-B-Abdeckung (12) eine oder mehrere Kunststoffrasten (30) daran aufweist.

3. Gehäuse nach einem der Ansprüche 1 und 2, wobei der eine oder die mehreren Clips (24) C-förmig oder U-förmig sind.

4. Gehäuse nach einem der Ansprüche 1 bis 3, wobei der eine oder die mehreren Clips (24) ein Material umfassen, das aus der aus Kunststoff, Metall, Gummi, thermoplastischem Polyurethan (TPU) und Kombinationen dieser Materialien bestehenden Gruppe ausgewählt ist.

5. Gehäuse nach einem der Ansprüche 1 bis 4, wobei der Kunststoff einen Thermoplasten umfasst.

6. Gehäuse nach einem der Ansprüche 1 bis 5, wobei der Kunststoff Polycarbonat umfasst.

7. Gehäuse nach Anspruch 6, wobei das Polycarbonat einen Füllstoff enthält, der aus der Gruppe ausgewählt ist, die aus Glasfasern, Kohlenstofffasern, Cellulosematerialien, Graphit, Graphen, Kohlenstoffnanoröhren, Kreide, Quarzpulver, Titandioxid, Silikaten, Talkum, Wollastonit, Montmorillonit, Kaolin, Zeolith, Vermikulit, Aluminiumoxid, Silika und Mischungen davon besteht.

8. Gehäuse nach einem der Ansprüche 1 bis 7, wobei das Material zur Abschirmung gegen elektromagnetische Interferenzen (EMI) (20) aus der aus Metallen, leitenden Kunststoffen und leitenden Polymeren bestehenden Gruppe ausgewählt ist.

9. Gehäuse nach einem der Ansprüche 1 bis 8, wobei die Mensch-Maschine-Schnittstelle (MMS) in einem der Folgenden enthalten ist, die aus der Gruppe ausgewählt sind, die aus einem Laptop-Computer, einem Tablet-Computer, einem Notebook-Computer, einem Desktop-Computer, einem Fernseher, einer Spielvorrichtung, einem Werbedisplay, einer Batterie, einem Monitor, einer Kamera, einem Server, einer Zugangssteuerung, einer Verkaufsstellenausstattung, einem E-Reader, einem Projektor, einem Thermostat, einem Smart-Home-Portal, einem Küchengerät, einem Automobilteil, einer medizinischen Vorrichtung, einer chirurgischen Vorrichtung, einem Smart Hub, einem Mobiltelefon, einem GPS-Empfänger, einem Transceiver, einer Fernbedienung, einem Scheinwerfer, einer Steuerelektronik, einem WLAN- oder LAN-Router, einem drahtgebundenen oder drahtlosen Zugangspunkt und einer Stromquelle besteht.

10. Gehäuse für eine Mensch-Maschine-Schnittstelle (MMS), umfassend:

    eine Kunststoffbaugruppe, die eine Kunststoff-B-Abdeckung umfasst,
    ein einschiebbares Bildschirmmodul (500) und
    einen Kunststoff-Bildschirmmodulrahmen (510), der eine Kunststoff-Bildschirmmodulrahmenkappe (512) mit einer oder mehreren Nuten umfasst, die darin eingeschnitten sind und eine oder mehrere Öffnungen für eine

Metallschraube (535) dort hindurch aufweisen,
wobei die Kunststoff-Bildschirmmodulrahmenkappe mit einer oder mehreren Metallschrauben (535), die durch die eine oder die mehreren Öffnungen eingeführt sind, an dem Kunststoff-Bildschirmmodulrahmen (510) befestigt ist, und
wobei der Kunststoff-Bildschirmmodulrahmen (510) das einschiebbare Bildschirmmodul (500) und die Kunststoff-B-Abdeckung umgibt, wobei ein Material zur Abschirmung gegen elektromagnetische Interferenzen (EMI) (520) durch einen oder mehrere Kunststoff-Heißnietzapfen (525) an der Kunststoff-B-Abdeckung angebracht ist und wobei das Material zur Abschirmung gegen elektromagnetische Interferenzen (EMI) (520) nach dem Gleiten in die eine mehrerer Nuten des Kunststoff-Bildschirmmodulrahmens (510) sandwichartig zwischen der Kunststoff-B-Abdeckung und dem einschiebbaren Bildschirmmodul (500) angeordnet ist.

**11.** Gehäuse nach Anspruch 10, wobei der Kunststoff einen Thermoplasten umfasst, wobei der Thermoplast Polycarbonat umfasst.

**12.** Gehäuse nach Anspruch 11, wobei das Polycarbonat einen Füllstoff enthält, der aus der Gruppe ausgewählt ist, die aus Glasfasern, Kohlenstofffasern, Cellulosematerialien, Graphit, Graphen, Kohlenstoffnanoröhren, Kreide, Quarzpulver, Titandioxid, Silikaten, Talkum, Wollastonit, Montmorillonit, Kaolin, Zeolith, Vermikulit, Aluminiumoxid, Silika und Mischungen davon besteht.

**13.** Gehäuse nach einem der Ansprüche 10 bis 12, wobei das Material zur Abschirmung gegen elektromagnetische Interferenzen (EMI) (520) mindestens eines enthält, das aus der aus Metallen, leitenden Kunststoffen und leitenden Polymeren bestehenden Gruppe ausgewählt ist.

**14.** Gehäuse nach einem der Ansprüche 10 bis 13, wobei die Mensch-Maschine-Schnittstelle (MMS) in einem der Folgenden enthalten ist, die aus der Gruppe ausgewählt sind, die aus einem Laptop-Computer, einem Tablet-Computer, einem Notebook-Computer, einem Desktop-Computer, einem Fernseher, einer Spielvorrichtung, einem Werbedisplay, einer Batterie, einem Monitor, einer Kamera, einem Server, einer Zugangssteuerung, einer Verkaufsstellenausstattung, einem E-Reader, einem Projektor, einem Thermostat, einem Smart-Home-Portal, einem Küchengerät, einem Automobilteil, einer medizinischen Vorrichtung, einer chirurgischen Vorrichtung, einem Smart Hub, einem Mobiltelefon, einem GPS-Empfänger, einem Transceiver, einer Fernbedienung, einem Scheinwerfer, einer Steuerelektronik, einem WLAN- oder LAN-Router, einem drahtgebundenen oder drahtlosen Zugangspunkt und einer Stromquelle besteht.

**15.** Verfahren zum Recycling des Gehäuses nach einem der Ansprüche 1 bis 14, wobei das Verfahren Folgendes umfasst:

(a) Zerlegen des Gehäuses,
(b) Entfernen aller nicht aus Kunststoff bestehenden Teile,
(c) mechanisches Zerkleinern des Gehäuses,
(d) Reinigen und/oder Desinfizieren und/oder Sortieren des Gehäuses,
(e) Unterziehen des Gehäuses einer Pyrolyse und/oder einer Chemolyse, um ein Monomer zu erhalten,
(f) Polymerisieren des Monomers zur Herstellung eines Polymers und
(g) optional Pelletieren des Polymers.

## Revendications

**1.** Boîtier pour interface homme-machine, IHM, comprenant :

un ensemble plastique (10) comprenant un couvercle en plastique « B » (12) comportant un ou plusieurs crochets en plastique encliquetables (14) faisant saillie de celui-ci et une ou plusieurs rainures (16) découpées dans celui-ci ;
un panneau d'affichage (18) pris en sandwich dans l'ensemble plastique (10) derrière le couvercle en plastique « B » (12) et devant un matériau de blindage contre les interférences électromagnétiques, IEM, (20) ; et
un couvercle en plastique « A » (22) comportant une ou plusieurs rainures (16) découpées dans celui-ci,
l'ensemble plastique (10) étant maintenu ensemble par une ou plusieurs attaches (24) coulissant le long de chaque côté de l'ensemble plastique (10),
la ou les attaches (24) coulissant dans la ou les rainures (16) du couvercle en plastique « B » (12) et un ou

plusieurs crochets en plastique encliquetables (14) et la ou les rainures (16) du couvercle en plastique « A », et le matériau de blindage contre les interférences électromagnétiques, IEM, (20) comportant un ou plusieurs œillets à pression (26) sur celui-ci, qui sont pressés sur un ou plusieurs boutons en plastique (28) faisant saillie d'une surface du couvercle en plastique « A » (22) pour fixer le matériau de blindage contre les interférences électromagnétiques, IEM, (20) au couvercle en plastique « A » (22).

**2.** Boîtier selon la revendication 1, le couvercle en plastique « B » (12) comportant un ou plusieurs éléments d'encliquetage en plastique (30) sur celui-ci.

**3.** Boîtier selon l'une des revendications 1 et 2, la ou les attaches (24) étant en forme de « C » ou en forme de « U ».

**4.** Boîtier selon l'une quelconque des revendications 1 à 3, la ou les attaches (24) comprenant un matériau choisi dans le groupe constitué par le plastique, le métal, le caoutchouc, le polyuréthane thermoplastique TPU, et des combinaisons de ces matériaux.

**5.** Procédé selon l'une quelconque des revendications 1 à 4, le plastique comprenant un thermoplastique.

**6.** Procédé selon l'une quelconque des revendications 1 à 5, le plastique comprenant un polycarbonate.

**7.** Boîtier selon la revendication 6, le polycarbonate contenant une charge choisie dans le groupe constitué par des fibres de verre, des fibres de carbone, des matières cellulosiques, du graphite, du graphène, des nanotubes de carbone, de la craie, de la poudre de quartz, du dioxyde de titane, des silicates, du talc, de la wollastonite, de la montmorillonite, du kaolin, de la zéolite, de la vermiculite, de l'oxyde d'aluminium, de la silice et des mélanges de ceux-ci.

**8.** Boîtier selon l'une quelconque des revendications 1 à 7, le matériau de blindage contre les interférences électromagnétiques, IME, (20) étant choisi dans le groupe constitué par les métaux, les plastiques conducteurs et les polymères conducteurs.

**9.** Boîtier selon l'une quelconque des revendications 1 à 8, l'interface homme-machine, IHM, étant incluse dans un élément sélectionné dans le groupe constitué par un ordinateur portable, une tablette informatique, un bloc-notes électronique, un ordinateur de bureau, une télévision, un dispositif de jeu, un affichage publicitaire, une batterie, un moniteur, une caméra, un serveur, un contrôle d'accès, un équipement de point de vente, une liseuse électronique, un projecteur, un thermostat, un portail domotique, un appareil de cuisine, une pièce automobile, un dispositif de soins de santé, un dispositif chirurgical, un concentrateur intelligent, un téléphone mobile, un récepteur GPS, un émetteur-récepteur, une télécommande, une lampe frontale, une électronique de commande, un routeur WLAN ou LAN, un point d'accès filaire ou sans fil et une source d'énergie électrique.

**10.** Boîtier pour interface homme-machine, IHM, comprenant :

un ensemble plastique comprenant un couvercle en plastique « B » ;
un écran d'affichage coulissant (500) ; et
un cadre d'affichage en plastique (510) comprenant un capuchon de cadre d'affichage en plastique (512), doté d'une ou de plusieurs rainures, découpées dans celui-ci et comportant une ou plusieurs ouvertures pour une vis métallique (535) le traversant,
le capuchon de cadre d'affichage en plastique étant fixé au cadre d'affichage en plastique (510) au moyen d'une ou de plusieurs vis métalliques (535) insérées à travers la ou les ouvertures, et
le cadre d'affichage en plastique (510) entourant l'écran d'affichage coulissant (500) et le couvercle en plastique « B », un matériau de protection contre les interférences électromagnétiques, IEM, (520) étant fixé au couvercle en plastique « B » par un ou plusieurs éléments de thermosoudage en plastique (525) et le matériau de protection contre les interférences électromagnétiques, IEM, (520) étant pris en sandwich entre le couvercle en plastique « B » et l'écran d'affichage coulissant (500) après avoir coulissé dans une ou plusieurs rainures du cadre d'affichage en plastique (510).

**11.** Boîtier selon la revendication 10, le plastique comprenant un thermoplastique, le thermoplastique comprenant un polycarbonate.

**12.** Boîtier selon la revendication 11, le polycarbonate contenant une charge choisie dans le groupe constitué par des

fibres de verre, des fibres de carbone, des matières cellulosiques, du graphite, du graphène, des nanotubes de carbone, de la craie, de la poudre de quartz, du dioxyde de titane, des silicates, du talc, de la wollastonite, de la montmorillonite, du kaolin, de la zéolite, de la vermiculite, de l'oxyde d'aluminium, de la silice et des mélanges de ceux-ci.

**13.** Boîtier selon l'une quelconque des revendications 10 à 12, le matériau de blindage contre les interférences électromagnétiques, IME, (520) contenant au moins un élément choisi dans le groupe constitué par les métaux, les plastiques conducteurs et les polymères conducteurs.

**14.** Boîtier selon l'une quelconque des revendications 10 à 13, l'interface homme-machine, IHM, étant incluse dans un élément sélectionné dans le groupe constitué par un ordinateur portable, une tablette informatique, un bloc-notes électronique, un ordinateur de bureau, une télévision, un dispositif de jeu, un affichage publicitaire, une batterie, un moniteur, une caméra, un serveur, un contrôle d'accès, un équipement de point de vente, une liseuse électronique, un projecteur, un thermostat, un portail domotique, un appareil de cuisine, une pièce automobile, un dispositif de soins de santé, un dispositif chirurgical, un concentrateur intelligent, un téléphone mobile, un récepteur GPS, un émetteur-récepteur, une télécommande, une lampe frontale, une électronique de commande, un routeur WLAN ou LAN, un point d'accès filaire ou sans fil et une source d'énergie électrique.

**15.** Procédé de recyclage du boîtier selon l'une quelconque des revendications 1 à 14, le procédé comprenant les étapes consistant à :

(a) démonter le boîtier ;
(b) retirer d'éventuelles pièces non plastiques ;
(c) effectuer un déchiquetage mécanique du boîtier ;
(d) effectuer au moins une opération parmi le nettoyage, la désinfection et le tri du boîtier ;
(e) soumettre le boîtier à au moins l'une parmi une pyrolyse et une chimiolyse pour obtenir un monomère ;
(f) polymériser le monomère pour produire un polymère, et
(g) éventuellement, granuler le polymère.

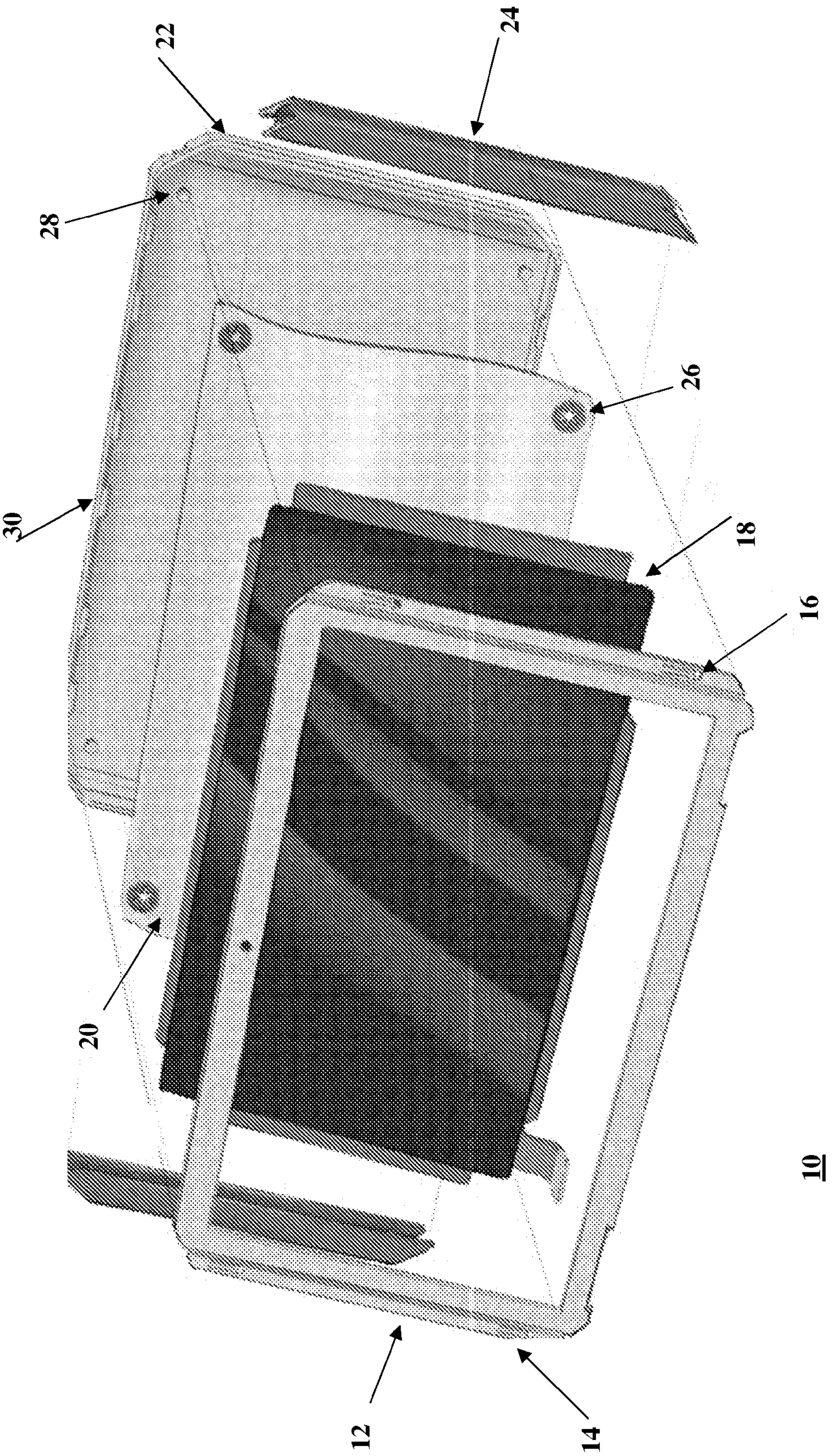


FIG. 1

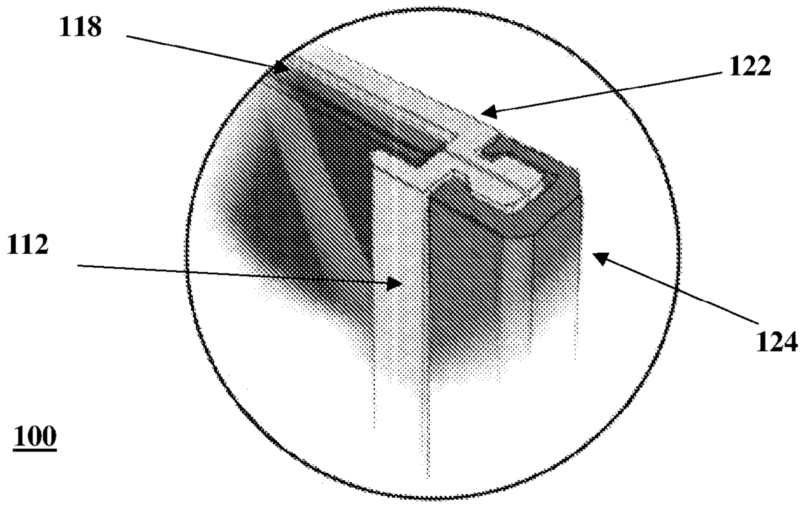


FIG. 2

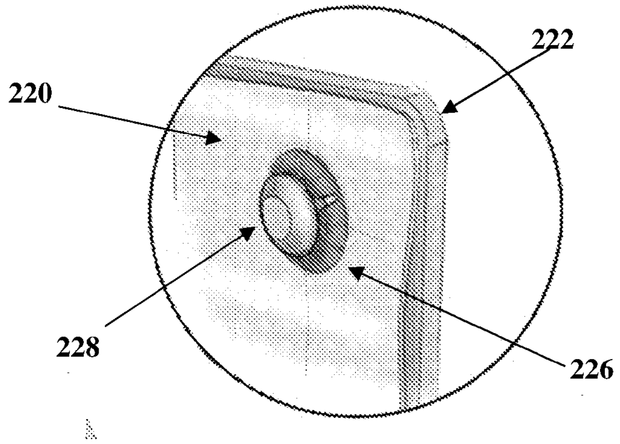


FIG. 3

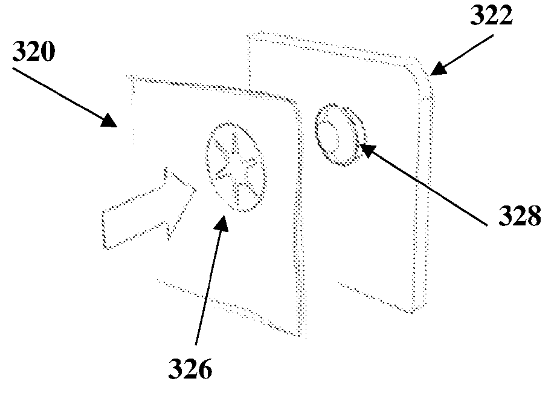


FIG. 4

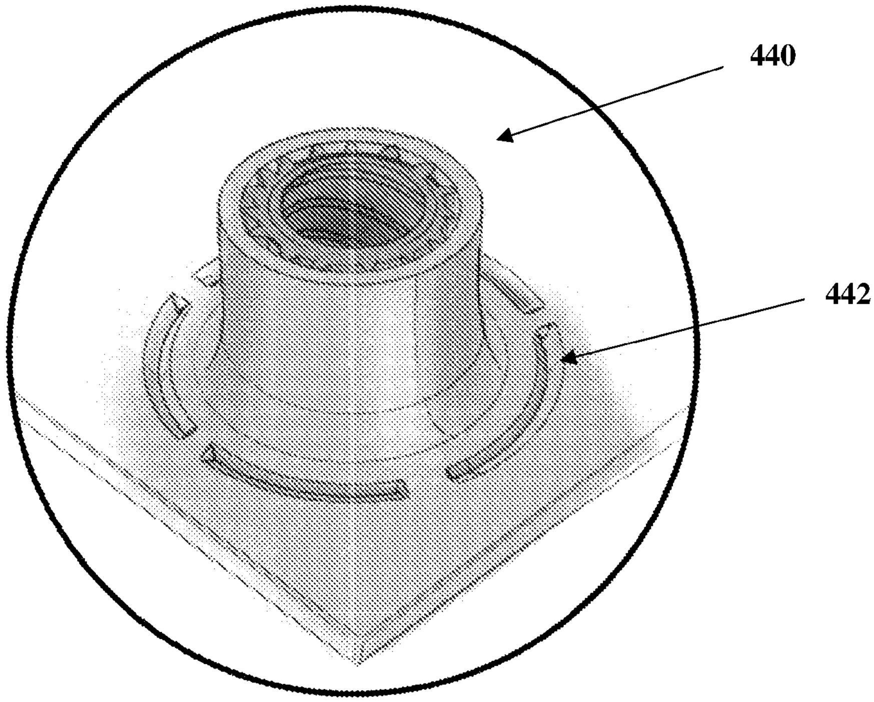


FIG. 5

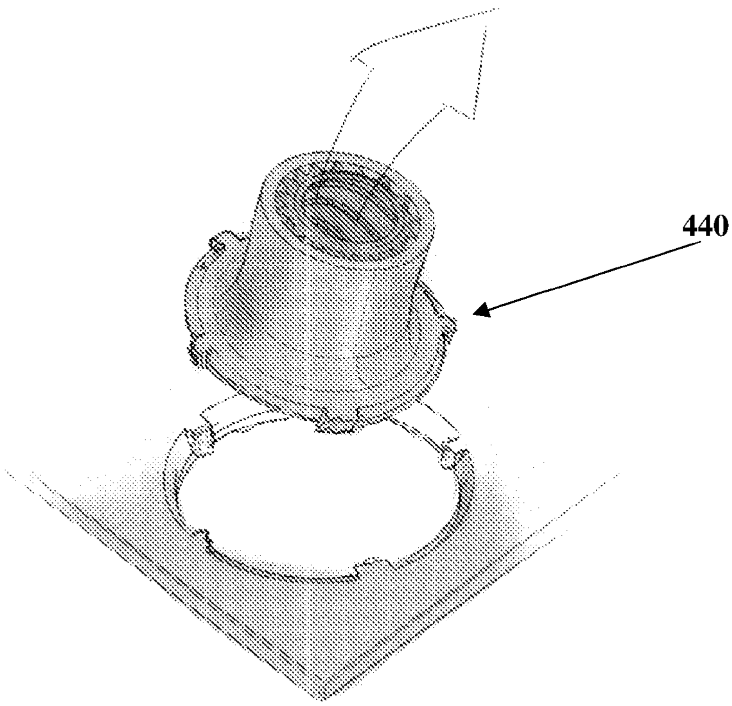


FIG. 6

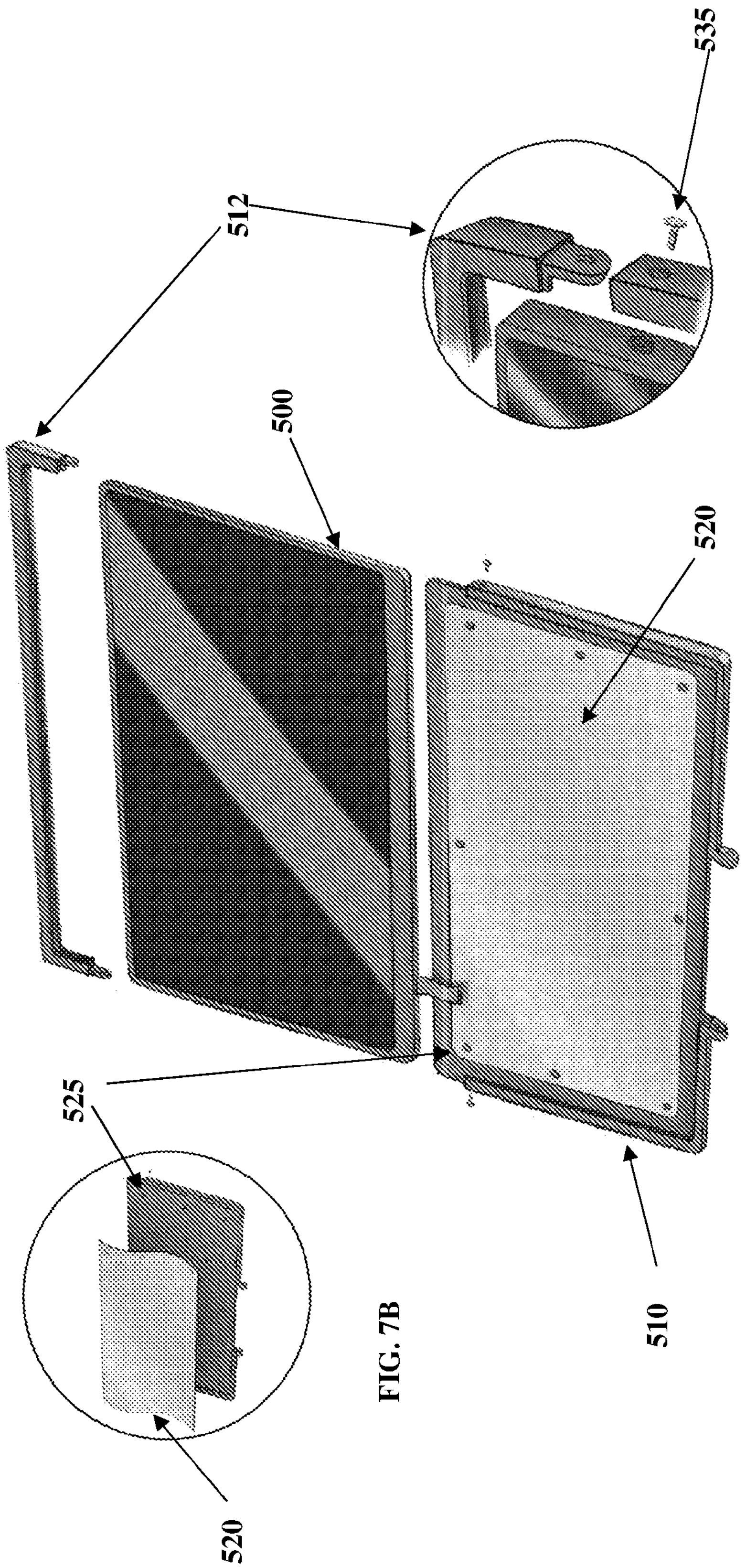


FIG. 7C

FIG. 7A

FIG. 7B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2022152560 A, Zhu
- US 5808863 A, Radloff
- US 5097002 A
- US 5340905 A
- US 5717057 A
- US 6596840 B
- US 6740730 B
- US 7071284 B
- US 2991273 A
- US 2999835 A
- US 2999846 A
- US 3148172 A
- US 3271367 A
- US 4982014 A
- DE 2036052 A
- DE 3832396 A
- FR 1561518 A1
- GB 1122003 A
- GB 1229482 A
- GB 1341318 A
- GB 1367790 A
- US 5288778 A
- US 5821380 A
- US 5883165 A
- US 7074351 B
- US 7169834 B
- US 8153239 B
- US 20050165148 A
- US 9167735 B
- US 9505903 B
- US 8722186 B
- US 8691393 B
- US 8222321 B


### Non-patent literature cited in the description


- Chemistry and Physics of Polycarbonates. **SCHNELL**. Polymer Reviews. Interscience Publishers, 1964, vol. 9
- Polycarbonates. **D. FREITAG** ; **U. GRIGO** ; **P.R. MÜLLER** ; **H. NOUVERTNÉ**. Encyclopedia of Polymer Science and Engineering. 1988, vol. 11, 648-718
- Polycarbonate, Polyacetale, Polyester, Celluloseester [Polycarbonates, Polyacetals, Polyesters, Cellulose Esters. **U. GRIGO** ; **K. KIRCHNER** ; **P.R. MÜLLER**. Kunststoff-Handbuch [Plastics Handbook. Carl Hanser Verlag, 1992, vol. 3/1, 117-299
- **H. SCHNELL**. Chemistry and Physics of Polycarbonates. Interscience Publishers, 1964, 28, 102
- **D.G. LEGRAND** ; **J.T. BENDLER**. Handbook of Polycarbonate Science and Technology. Marcel Dekker, 2000, 72
- **HANS ZWEIFEL**. Plastics Additives Handbook. Hanser Verlag, 2000
- *CHEMICAL ABSTRACTS*, 13676-91-0
- *CHEMICAL ABSTRACTS*, 116-75-6
- *CHEMICAL ABSTRACTS*, 147-14-8
- *CHEMICAL ABSTRACTS*, 1328-53-6
- *CHEMICAL ABSTRACTS*, 23949-66-8